# DEMANDE DE BREVET EUROPEEN

(11) **EP 4 304 313 A1**
(43) Date de publication de la demande: **10.01.2024**
(21) Numéro de dépôt: 23180990.6
(22) Date de dépôt: 22.06.2023
(51) Int. Cl.: H10B 10/00, H01L 27/12

(54) **DISPOSITIF SEMICONDUCTEUR DU TYPE SILICIUM SUR ISOLANT COMPRENANT UN CIRCUIT DE MÉMOIRE VIVE STATIQUE, ET PROCÉDÉ DE FABRICATION CORRESPONDANT**

(30) Priorité: 06.07.2022 FR 2206897
(71) Demandeur: STMicroelectronics Crolles 2 SAS, 38920 Crolles (FR); STMicroelectronics International N.V., 1228 Plan-les-Ouates, Geneva (CH); STMICROELECTRONICS SA, 92120 Montrouge (FR)
(72) Inventeur: Weber, Olivier, 38000 Grenoble (FR); Dhori, Kedar Janardan, 201010 Ghaziabad (IN); Kumar, Promod, 201312 Greater Noida (IN); Ahmed, Shafquat Jahan, 201308 Greater Noida (IN); Lecocq, Christophe, 38760 Varces (FR); Urard, Pascal, 38570 Theys (FR)
(74) Mandataire: Casalonga

(57) **Abrégé**

Le dispositif semiconducteur du type silicium sur isolant, comprenant un film semiconducteur (ACTn, ACTp) séparé d'un substrat porteur (SUB) par une région diélectrique enterrée (BOX), comprend un circuit de mémoire vive statique muni d'au moins une cellule-mémoire (CLL) comportant des transistors NMOS (NM) et des transistors PMOS (PM) comprenant chacun une couche diélectrique de grille (EG) ayant une épaisseur (tEG) supérieure à 3 nanomètres et une région active (ACTn, ACTp) dans le film semiconducteur respectif, la région active des transistors PMOS (ACTp) étant faite en alliage de silicium-germanium.

## Description

Des modes de réalisation et de mise en oeuvre concernent les dispositif semiconducteur du type silicium sur isolant, en particulier comprenant un circuit de mémoire vive statique.

Les dispositifs semiconducteurs du type silicium sur isolant, usuellement réalisés au sein d'un circuit intégré, comprennent typiquement un film semiconducteur séparé d'un substrat porteur par une région diélectrique enterrée. Par exemple, le film semiconducteur a avantageusement une épaisseur suffisamment fine pour être complètement déserté de charges minoritaires, dans une technologie appelée « FDSOI » (pour « Fully Depleted Silicon On Insulator » en anglais).

Classiquement, les mémoires vives statiques (usuellement « SRAM » pour « Static Random Access Memory » en anglais) comportent des cellules mémoires munies de deux transistors PMOS et deux transistors NMOS (désignation usuelles et bien connues de l'homme de l'art pour « Métal Oxyde Semiconducteur de type P/type N ») connectés entre une borne d'alimentation et une borne de masse de manière à former deux inverseurs tête-bêche ; ainsi que typiquement deux transistors d'accès, usuellement des transistors NMOS, couplés entre des lignes de bit et les noeuds de données (c'est-à-dire les noeuds d'entrées-sorties des inverseurs) et commandés par un signal transmis sur une ligne de mot.

L'écriture et la lecture d'une donnée dans une cellule SRAM sont faites via les transistors d'accès et les lignes de bit, en imposant en écriture, ou en mesurant en lecture, un niveau de tension sur les noeuds de données. La rétention d'une donnée dans une cellule mémoire est obtenue par l'état d'équilibre du signal généré sur les noeuds de données du montage des inverseurs tête-bêche.

Dans le mode « lecture-écriture », la tension d'alimentation est générée à un niveau nominal, c'est-à-dire un niveau de fonctionnement normal des transistors, par exemple compris entre 0,8 volts et 1,2 volts pour des dispositif semiconducteur du type silicium sur isolant, afin d'avoir un état d'équilibre bien défini et discernable dans la cellule mémoire.

Dans le mode « rétention » d'une cellule SRAM, il est avantageux de réduire autant que possible la consommation énergétique du dispositif. La tension d'alimentation peut être minimisée mais reste néanmoins supérieure aux tensions de seuil des transistors de la cellule, pour ne pas perdre l'état d'équilibre de la cellule SRAM et la donnée ainsi retenue. Il est donc souhaitable de proposer des technologies de cellules mémoires SRAM présentant des fuites de courants les plus faibles possibles. Les technologies FDSOI les plus performante en matière de fuites de courante (usuellement appelées « ultra faible fuites » ou « ULL » pour « Ultra Low Leakage » en anglais) présentent des résultats de l'ordre de 1 pico Ampère (ou 1000 femto Ampères) dans le mode rétention.

Il existe un besoin de proposer des technologies de mémoires SRAM présentant une consommation énergétique encore plus faible, en particulier dans le mode rétention des données.

Selon un aspect, il est proposé à cet égard un dispositif semiconducteur du type silicium sur isolant comprenant un film semiconducteur séparé d'un substrat porteur par une région diélectrique enterrée, le dispositif comprenant un circuit de mémoire vive statique muni d'au moins une cellule-mémoire comportant des transistors NMOS et des transistors PMOS comprenant chacun une couche diélectrique de grille ayant une épaisseur supérieure à 3 nanomètres et une région active dans le film semiconducteur respectif, la région active des transistors PMOS étant faite en alliage de silicium-germanium.

L'épaisseur, supérieure à 3 nanomètres, de la couche diélectrique de grille des transistors est grande par rapport aux architectures typiques de mémoire SRAM en technologie FDSOI. En effet, les épaisseurs des couches diélectriques de grilles sont classiquement de 1 nanomètre à 1,5 nanomètres. En conséquence, la cellule mémoire définie selon cet aspect présente des fuites de courant de grille extrêmement faibles. En contrepartie, la cellule mémoire selon cet aspect peut présenter un encombrement plus grand que dans une architecture classique (épaisseur de 1 nm à 1,5 nm), et d'autre part les tensions de seuil des transistors NMOS et PMOS sont plus grandes que dans une architecture classique (épaisseur de 1 nm à 1,5 nm). La région active des transistors PMOS faite en alliage de silicium-germanium, présentant en particulier une contrainte en compression dans la direction du canal (source-drain) du transistor, permet d'abaisser la tension de seuil des transistors PMOS et ainsi de bénéficier de performances adéquates, notamment en matière de stabilité en mode de lecture-écriture, sans augmenter les tensions d'alimentation. L'augmentation de la tension de seuil des transistors NMOS permet avantageusement de réduire les fuites de courants vers la masse par les régions de conductions des transistors NMOS.

On entend, de la manière habituelle et bien connue de l'homme de l'art, le terme « région active » désignant des régions des films semiconducteurs qui ne sont pas recouvertes de régions d'isolation latérales, telles que des tranchées d'isolation peu profondes (usuellement « Shallow Trench Isolation » en anglais), de sorte que des interfaces entre les régions de grille et les régions de canal, ainsi que les régions de source et de drain des transistors sont formées dans lesdites régions actives.

Selon un mode de réalisation, les couches diélectriques de grille des transistors NMOS et des transistors PMOS ont une épaisseur, prise entre la région active et une région conductrice de grille, comprise entre 3,5 nanomètres et 6 nanomètres.

Par exemple, les couches diélectriques de grille des transistors NMOS et des transistors PMOS comportent une partie en oxyde de silicium, par exemple en oxynitrure de silicium « SiON » (ou SiOₓN_{y}, typiquement Si₂O₂N), ayant une épaisseur comprise entre 1 nanomètre et 3,5 nanomètres ; et éventuellement une partie en diélectrique « haute permittivité » (usuellement « high-k » en anglais), tel que l'oxyde d'hafnium, ayant une épaisseur de sensiblement 2,5 nanomètres, surmontant la partie en oxyde de silicium, notamment dans les technologies désignées en anglais « high-k/metal gate » c'est-à-dire les technologies comportant le diélectrique « haute permittivité » et une partie en métal dans la région conductrice de grille.

Les épaisseurs totales des couches diélectriques de grille, comprises entre 3,5 nm et 6 nm, peuvent par exemple correspondre à des diélectriques de grille de transistors « moyenne tension » destinés à fonctionner à des tensions allant jusqu'à 1,8 volts, contrairement aux architectures classiques (de 1 nm à 1,5 nm) correspondant à des diélectriques de grille de transistors « basse tension » destinés à fonctionner à des tensions inférieures à 1,2 volts.

D'autres circuits que le circuit de mémoire vive statique appartenant au dispositif semiconducteur peuvent incorporer des transistors « moyenne tension », c'est-à-dire des transistors ayant des couches diélectriques de grille d'épaisseurs comprises entre 3,5 nm et 6 nm et destinés à fonctionner à des tensions comprises entre 1,2 volts et 1,8 volts, et éventuellement incorporer des transistors « basse tension », c'est-à-dire des transistors ayant des couches diélectriques de grille d'épaisseurs comprises entre 1 nm et 1,5 nm et destinés à fonctionner à des tensions comprises entre 0,5 volts et 1,2 volts.

Selon un mode de réalisation, les régions actives s'étendent dans le circuit de mémoire le long d'une première direction de manière à incorporer d'autres cellules-mémoires, et de manière à ne pas relaxer une contrainte en compression dans la première direction de l'alliage de silicium-germanium.

Cela correspond à une architecture dite de « région active continue » pour les transistors PMOS, qui permet de bénéficier de la contrainte en compression dans la longueur du canal des transistors PMOS, mais qui engendre par construction la présence d'un transistor supplémentaire, appelé « grille liée » (usuellement « gate tied » en anglais), avantageusement branché pour être toujours désactivé.

Par ailleurs, la première direction correspond à la longueur du canal du transistor, c'est-à-dire la direction entre la source et le drain du transistor.

Selon un mode de réalisation, les transistors NMOS et les transistors PMOS sont situées dans des caissons respectivement dopés du substrat porteur, le dispositif comportant un circuit de polarisation configuré pour générer, dans les caissons semiconducteurs respectifs du substrat porteur, des tensions adaptées pour des polarisations arrières inverses des transistors PMOS et NMOS.

Les tensions de polarisation arrière créent un effet de champ dans la région active engendré par la polarisation du substrat porteur sous la région diélectrique enterrée. La polarisation arrière inverse permet de « ralentir » le fonctionnement des transistors en augmentant leurs tensions de seuil et de diminuer les fuites de courant dans le canal des transistors.

Selon un mode de réalisation, les transistors NMOS sont situés dans un caisson dopé de type P dans le substrat porteur, les transistors PMOS sont situés dans un caisson dopé de type N dans le substrat porteur, et le circuit de polarisation est configuré pour générer une tension de polarisation arrière inverse comprise entre 0 volt et -2 volts dans les caissons dopés de type P, et une tension de polarisation arrière inverse comprise entre 0 volt et +2 volts dans les caissons dopés de type N.

Selon un mode de réalisation, le circuit de polarisation est configuré pour générer lesdites tensions adaptées pour des polarisations arrières inverses des transistors PMOS et NMOS, dans un mode de rétention de donnée de ladite cellule-mémoire et pas dans un mode de lecture-écriture de ladite cellule-mémoire, le circuit de polarisation étant configuré pour générer une tension d'alimentation pour ladite cellule-mémoire ayant un niveau nominal dans le mode de lecture-écriture, et ayant 50% à 85% du niveau nominal dans le mode de rétention de donnée.

Selon un autre aspect, il est proposé un procédé de fabrication d'un dispositif semiconducteur du type silicium sur isolant comprenant un film semiconducteur séparé d'un substrat porteur par une région diélectrique enterrée, comprenant une fabrication d'au moins une cellule-mémoire d'un circuit de mémoire vive statique comprenant : une fabrication de transistors NMOS et de transistors PMOS comprenant chacun une formation d'une région active dans le film semiconducteur respectif, et une formation d'une couche diélectrique de grille ayant une épaisseur supérieure à 3 nanomètres, la région active des transistors PMOS étant faite en alliage de silicium-germanium.

Selon un mode de mise en oeuvre, les couches diélectriques de grille des transistors NMOS et des transistors PMOS ont une épaisseur, prise entre la région active et une région conductrice de grille, comprise entre 3,5 nanomètres et 6 nanomètres.

Selon un mode de mise en oeuvre, les régions actives sont faites en s'étendant dans le circuit de mémoire le long d'une première direction de manière à incorporer d'autres cellules-mémoires, et de manière à ne pas relaxer une contrainte en compression dans la première direction de l'alliage de silicium-germanium.

Selon un mode de mise en oeuvre, la fabrication des transistors NMOS et des transistors PMOS comprend une formation de caissons semiconducteurs respectivement dopés dans le substrat porteur, les transistors PMOS et NMOS étant situés dans les caissons ayant un type de dopage respectif, le procédé comprenant en outre une fabrication d'un circuit de polarisation apte à générer, dans les caissons semiconducteurs respectifs du substrat porteur, des tensions adaptées pour des polarisations arrières inverses des transistors PMOS et NMOS.

Selon un mode de mise en oeuvre, les caissons dans lesquels se situent les transistors NMOS sont dopés de type P, les caissons dans lesquels se situent les transistors PMOS sont dopés de type N, et le circuit de polarisation est fabriqué de manière à générer une tension de polarisation arrière inverse comprise entre 0 volt et -2 volts dans les caissons dopés de type P, et une tension de polarisation arrière inverse comprise entre 0 volt et +2 volts dans les caissons dopés de type N.

Selon un mode de mise en oeuvre, le circuit de polarisation est fabriqué de manière à générer lesdites tensions adaptées pour des polarisations arrières inverses des transistors PMOS et NMOS, dans un mode de rétention de donnée de ladite cellule-mémoire et pas dans un mode de lecture-écriture de ladite cellule-mémoire, le circuit de polarisation étant fabriqué de manière à générer une tension d'alimentation pour ladite cellule-mémoire ayant un niveau nominal dans le mode de lecture-écriture, et ayant 50% à 85% du niveau nominal dans le mode de rétention de donnée.

D'autres avantages et caractéristiques de l'invention apparaîtront à l'examen de la description détaillée de modes de réalisation et de mise en oeuvre, nullement limitatifs, et des dessins annexés, sur lesquels :
[Fig 1] ;
[Fig 2] ;
[Fig 3] ;
[Fig 4] ;

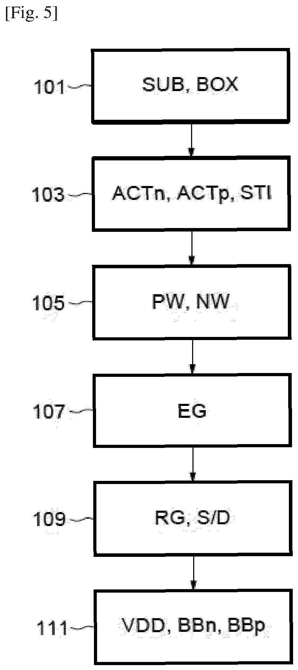

[Fig 5] illustrent des modes de réalisation et de mise en oeuvre de l'invention.

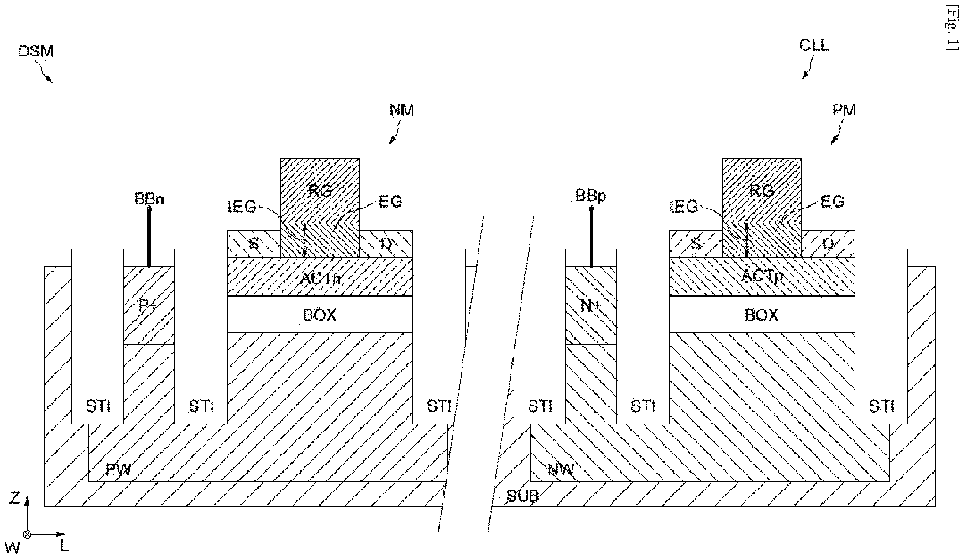

La figure 1 illustre schématiquement un dispositif semiconducteur DSM du type silicium sur isolant, comprenant un transistor NM du type NMOS et un transistor PM du type PMOS, que l'on désignera dans la suite par les termes « transistor NMOS » et « transistor PMOS ».

Dans la technologie silicium sur isolant, les transistors NMOS et les transistors PMOS sont réalisés à partir d'une structure de substrat comportant un film semiconducteur ACTn, ACTp séparé d'un substrat porteur SUB par une région diélectrique enterrée BOX.

Les transistors NMOS et PMOS sont en particulier adaptés pour intégrer des cellules-mémoires CLL d'un circuit de mémoire vive statique « SRAM » à ultra-faibles fuites.

A cet égard, les transistors NMOS et les transistors PMOS comprennent en particulier chacun une couche, ou « région », diélectrique de grille EG ayant une épaisseur tEG supérieure à 3 nanomètres, et, en particulier également, le transistor PMOS comporte une région active ACTp dans le film semiconducteur respectif faite en alliage de silicium-germanium. En pratique, tout le film semiconducteur ACTp utilisé pour les transistors PMOS est fait en alliage de silicium-germanium.

Par exemple, les couches diélectriques de grille EG des transistors NMOS et des transistors PMOS ont une épaisseur tEG, prise verticalement Z entre la région active ACTn, ACTp et la région conductrice de grille RG (voir ci-après), comprise entre 3,5 nanomètres et 6 nanomètres, voire 7 nanomètres.

Avantageusement, les couches diélectriques de grille EG ont une épaisseur électrique équivalente de sensiblement 4 nanomètres ou moins. L'épaisseur électrique équivalente correspond à l'épaisseur t d'un diélectrique ayant une permittivité ε de référence, par exemple celle du dioxyde de silicium SiO₂, résultant, à surfaces S égales, à une même valeur capacitive C selon la formule C=ε(S/t).

Ainsi une réduction de l'épaisseur électrique permet d'augmenter la valeur capacitive de la couche diélectrique, ce qui est avantageux en matière de performances, sans réduire l'épaisseur physique de la couche diélectrique, ce qui est avantageux en matière de fuite de courant de grille.

Par exemple, les couches diélectriques de grille EG peuvent comporter à cet égard une partie en oxynitrure de silicium « SiON » (ou SiOₓN_{y}, typiquement Si₂O₂N), ayant une épaisseur comprise entre 1 nanomètre et 4,5 nanomètres, et une partie en diélectrique « haute permittivité » (usuellement « high-k » en anglais), tel que l'oxyde d'hafnium, ayant une épaisseur de sensiblement 2,5 nanomètres, surmontant la partie en oxyde de silicium. Une épaisseur physique de par exemple sensiblement 6 nanomètres (3,5 + 2,5) avec ces matériaux correspond à une épaisseur électrique équivalent de sensiblement 4 nanomètres.

Les transistors NMOS et PMOS comportent par ailleurs de façon conventionnelle une région conductrice de grille RG située sur la couche diélectrique de grille EG, et incluant par exemple une couche de métal ainsi qu'un volume de silicium polycristallin, ainsi que des régions de source S et de drain D implantées dans des régions actives respectives ACTn, ACTp.

Les régions actives ACTn, ACTp sont situées dans le film semiconducteur du substrat du type silicium sur isolant, et sont délimitées par des structures d'isolation latérales STI, usuellement des tranchées d'isolation peu profondes. Les régions actives ACTn des transistors NMOS sont par exemple faites en silicium intrinsèque.

Enfin, les transistors NMOS sont situés en regard de caissons PW dopés de type P, implantés dans le substrat porteur SUB, et les transistors PMOS sont située en regard de caissons NW dopés de type N, implantés dans le substrat porteur SUB, c'est-à-dire dans une configuration correspondant à une structure « régulière » de caissons (par opposition à une structure « retournée » de caissons dans laquelle les transistors NMOS se situent en regard d'un caisson du type N du substrat porteur SUB, et les transistors PMOS en regard d'un caisson du type P du substrat porteur SUB).

La structure « régulière » de caissons permet avantageusement de mettre en oeuvre des polarisations arrières inverses des transistors NMOS et PMOS, du fait que les jonctions PN entre lesdits caissons sont bloquantes dans cette condition de polarisations (polarisations négatives dans les caissons dopés de type P et positives dans les caissons dopés de type N). Les caissons semiconducteurs PW, NW comportent à cet égard des prises de contact respectives P+, N+, typiquement dans une ouverture de la région diélectrique enterrée BOX formée entre deux tranchées d'isolation peu profondes STI, et par exemple en retrait des circuits comportant les transistors NM, PM.

Les conditions de polarisation arrière BBn, BBp correspondent à un effet de champ dans la région active ACTn, ACTp engendré au travers de la région diélectrique enterrée BOX par la polarisation du substrat porteur SUB (caissons PW, NW). La polarisation arrière inverse comprend une polarisation négative pour les transistors NMOS et une polarisation positive pour les transistors PMOS, ce qui permet de « ralentir » le fonctionnement des transistors et de diminuer les fuites de courant vers le substrat porteur SUB.

Le dispositif semiconducteur DSM comporte un circuit de polarisation ALM, par exemple au sein d'un circuit d'alimentation électrique du dispositif, configuré pour générer dans les caissons semiconducteurs respectifs PW, NW du substrat porteur SUB, des tensions BBn, BBp adaptées pour des polarisations arrières inverses des transistors PMOS et NMOS.

Par exemple, la tension de polarisation arrière inverse BBn adaptée pour les transistors NMOS et appliquée dans les caissons PW dopés de type P, est comprise entre 0 volt et -2 volts ; et la tension de polarisation arrière inverse BBp adaptée pour les transistors PMOS et appliquée dans les caissons NW dopés de type N, est comprise entre 0 volt et +2 volts.

De façon avantageuse, le circuit de polarisation ALM est configuré pour générer lesdites tensions BBn, BBp de polarisations arrières inverses des transistors PMOS et NMOS, dans un mode de rétention de donnée de ladite cellule-mémoire CLL et pas de polarisation arrière dans un mode de lecture-écriture de ladite cellule-mémoire CLL.

En outre, le circuit de polarisation ALM peut être configuré pour générer une tension d'alimentation VDD pour ladite cellule-mémoire CLL ayant un niveau nominal dans le mode de lecture-écriture, et ayant 50% à 85% du niveau nominal dans le mode de rétention de donnée.

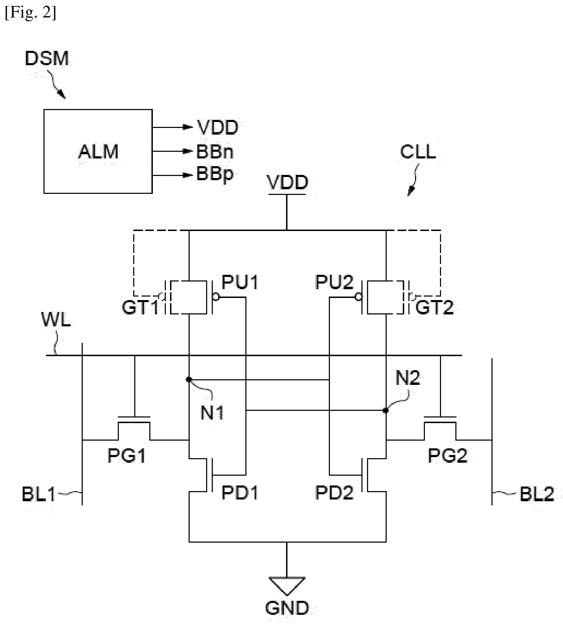

On se réfère à cet égard à la figure 2.

La figure 2 illustre un schéma électrique d'un cellule mémoire CLL de mémoire vive statique SRAM comportant des transistors NMOS et des transistors PMOS tels que décrits précédemment en relation avec la figure 1.

La cellule mémoire comporte deux transistors PMOS dits « de remontée » (« pull-up » en anglais) PU1, PU2 et deux transistors NMOS dits « de rabaissement » (« pull-down » en anglais) PD1, PD2 connectés entre une borne d'alimentation VDD et une borne de masse GND de manière à former deux inverseurs tête-bêche. Le noeud de sortie N1 du premier inverseur PU1, PD1 (ou « premier noeud de donnée N1 ») est couplé à l'entrée du deuxième inverseur PU2, PD2, et le noeud de sortie N2 (ou « deuxième noeud de donnée N2 ») du deuxième inverseur PU2, PD2 est couplé à l'entrée du premier inverseur PU1, PD1.

En outre, la cellule CLL comporte conventionnellement deux transistors NMOS d'accès PG1, PG2 permettant de sélectionner la cellule en lecture et en écriture. Le premier transistor d'accès PG1 est couplé entre une ligne de bit BL1 et le premier noeud de données N1 et est commandé par un signal transmis sur une ligne de mot WL. Le deuxième transistor d'accès PG2 est couplé entre une autre ligne de bit BL2 et le deuxième noeud de données N2 et est commandé par le signal transmis sur la ligne de mot WL.

L'écriture et la lecture d'une donnée dans la cellule CLL sont faites via les transistors d'accès PG1, PG2, en mesurant, via la ligne de bit respective BL1, BL2, le niveau de tension d'au moins l'un des noeuds de donnée N1, N2 en lecture ; et en imposant, via la ligne de bit respective BL1, BL2, un niveau de tension sur au moins l'un des noeuds de données N1, N2 en écriture.

La rétention d'une donnée dans une cellule mémoire est obtenu par l'état d'équilibre du signal généré sur les noeuds de données N1, N2 du montage des deux inverseurs tête-bêche PU1-PD1, PU2-PD2.

Dans le mode lecture-écriture, la tension d'alimentation VDD est générée par le circuit de polarisation ALM à un niveau nominal, c'est-à-dire un niveau de fonctionnement normal des transistors PU1, PD1, PU2, PD2, par exemple compris entre 0,8 volts et 1,2 volts, préférentiellement à 0,8 volts.

Dans le mode rétention d'une cellule SRAM, la tension d'alimentation VDD est générée par le circuit de polarisation ALM à un niveau économique, par exemple 50% à 85% du niveau nominal, c'est-à-dire entre 0,4 volts et 1,0 volt, préférentiellement à sensiblement 0,6 volts.

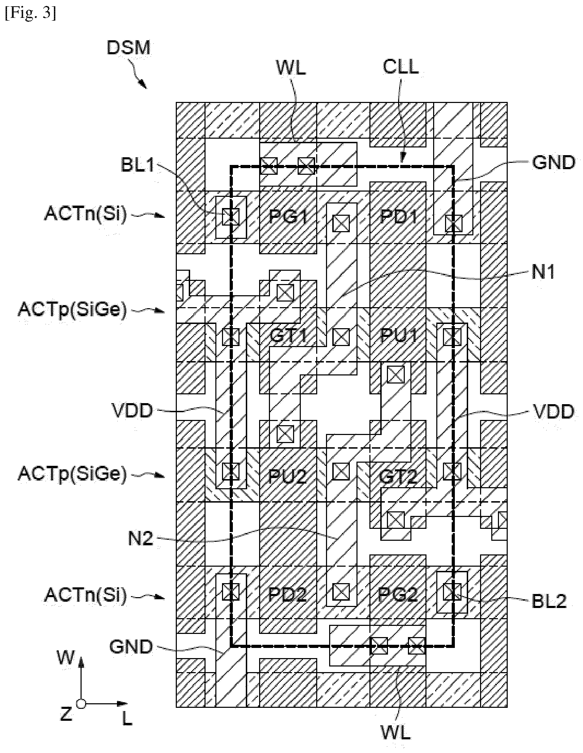

La figure 3 illustre un exemple de plan de disposition en vue du dessus (usuellement « layout » en anglais) du circuit d'une cellule mémoire CLL telle que décrite précédemment en relation avec les figures 1 et 2.

Les mêmes éléments supportent les mêmes références que dans les figures 1 et 2 et ne seront pas tous détaillés à nouveau ici.

On notera en particulier que les régions actives ACTn (Si), ACTp (SiGe) s'étendent dans le circuit de mémoire le long d'une première direction L, de part et d'autre du contour de la cellule mémoire CLL, incorporant ainsi des cellules-mémoires voisines (à gauche et à droite de la cellule CLL, dans l'orientation de la figure 3).

Cela correspond à une architecture dite de « région active continue » des régions actives en alliage de silicium-germanium ACTp (SiGe) des transistors PMOS.

Cela permet de ne pas relaxer une contrainte en compression dans la première direction L de l'alliage de silicium-germanium ACTp (SiGe) et ainsi de bénéficier d'améliorations des performances des transistors PMOS, notamment une réduction de la tension de seuil des transistors PMOS, et une faible variabilité sur les tensions de seuil des transistors PMOS.

Par contre, cela engendre une réalisation d'un transistor « parasite » GT1, GT2 dans chacune des régions actives ACTp des transistor PMOS de remontée PU1, PU2 fonctionnels pour la cellule CLL. Les deux transistors PMOS parasites GT1, GT2 sont désactivés en connectant leurs grilles et leurs sources à la borne de tension d'alimentation VDD, et sont usuellement appelés à cet égard « transistors à grille liée » (« gate tied » en anglais). Dans la figure 2, les transistors PMOS parasites GT1, GT2 sont représentés en traits interrompus du fait de leur présence mais de leur état désactivé.

Les transistors à grille liée GT1, GT2 pourront introduire un courant de fuite additionnel à celui de la cellule mémoire CLL en mode éteint ou en mode rétention (usuellement « en mode off-state »), mais négligeable par rapport à la consommation de la cellule mémoire en mode de lecture/écriture. Cela étant, même en mode éteint ou en mode rétention, les fuites du transistor « grille liée » sont faibles, du fait de l'épaisseur de sa couche diélectrique de grille, supérieure à 3 nanomètres, et d'une grande longueur de grille (dans la première direction L), par exemple supérieure à 100 nm.

La première direction L correspond à la longueur des transistors, c'est-à-dire dans la direction source-drain des transistors. La largeur W des transistors est définie par l'étendue des régions actives dans une deuxième direction W perpendiculaire à la première direction L et à la direction verticale Z.

Par exemple, les transistor NMOS et PMOS de la cellule CLL peuvent avoir une longueur de canal, dans la première direction L, comprise en 100 nm et 200 nm, et une largeur de canal, dans la deuxième direction W, comprise entre 100 nm et 200 nm. Les longueurs (L) et largeurs (W) des transistors de la cellule CLL sont relativement encombrantes, mais permettent, vis-à-vis de l'épaisseur de la couche diélectrique de grille EG, d'assurer respectivement un bon contrôle électrostatique des porteurs dans le canal (et donc moins de fuites entre les régions de source et de drain), et un courant de conduction suffisant pour le fonctionnement de la cellule mémoire SRAM.

Cela étant, les fuites de courant dans une cellule mémoire CLL telle que décrite en relation avec les figures 1 à 3 sont extrêmement faibles, par exemple sensiblement cinquante fois inférieures aux fuites de courants des cellules mémoire à « ultra faible fuite ».

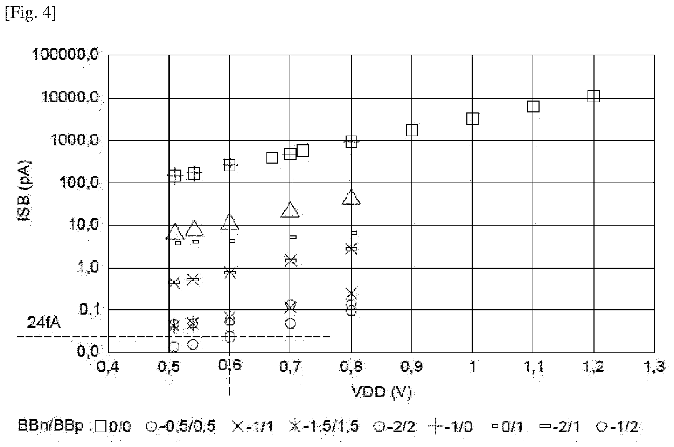

On se réfère à cet égard à la figure 4.

La figure 4 illustre des résultats de l'intensité des fuites de courant ISB, en pico Ampères (10⁻¹² A), d'une cellule mémoire CLL telle que décrite précédemment en relation avec les figures 1 à 3, en mode rétention, en fonction du niveau de la tension d'alimentation VDD, en volts, et pour différentes polarisations arrières inverses BBn/BBp.

On notera qu'à une tension d'alimentation VDD de 0,6 volts en mode rétention, avec des polarisations arrières inverses à BBn=-2 volts et BBp=+2 volts (BBn/BBp : -2/2), l'intensité des fuites de courant ISB dans la cellule mémoire CLL est de sensiblement 24 femto Ampère (24×10⁻¹⁵ A).

A titre de comparaison, les cellules de mémoires SRAM à ultra faible fuite en technologie FDSOI conventionnelles présentent des fuites de l'ordre de 1 à 1,5 pico Ampères en mode rétention. En d'autres termes, la cellule mémoire CLL telle que décrite ci-avant en relation avec les figures 1 à 3 présente des fuites de courant 50 fois plus petites que les technologies conventionnelles.

On notera en outre que d'autres conditions de tensions d'alimentation VDD et/ou de polarisation arrière BBn/BBp donnent des résultats satisfaisants. Par exemple : à une tension d'alimentation VDD de 0,8 volts avec des polarisations arrières inverses à BBn/BBp : -2/2, l'intensité des fuites de courant ISB dans la cellule mémoire CLL est inférieure à 100 femto Ampère ; à une tension d'alimentation VDD de 0,6 volts avec des polarisations arrières inverses à BBn/BBp : -1/1, l'intensité des fuites de courant ISB dans la cellule mémoire CLL est inférieure à 1 pico Ampère.

La figure 5 illustre un exemple simplifié de procédé de fabrication d'un dispositif semiconducteur DSM tel que décrit précédemment en relation avec les figures 1 à 4, en particulier la fabrication des transistors NMOS et PMOS des cellules mémoires CLL.

A une étape 101, on a préparé le substrat du type silicium sur isolant comprenant un film semiconducteur en silicium intrinsèque (ACT), séparé d'un substrat porteur SUB par une région diélectrique enterrée BOX.

A une étape 103 on modifie le matériau (initialement du silicium intrinsèque) dans les régions actives ACTp des futurs transistors PMOS, par exemple au moyen d'une technique usuellement appelée « condensation ». La technique de condensation comprend d'abord une croissance par épitaxie sélective de silicium-germanium sur le film semiconducteur en silicium intrinsèque des zones accueillant les transistors PMOS ; ensuite, on fait diffuser le germanium en profondeur (vers le bas) dans le film semiconducteur ; la diffusion est faite par oxydation de la région épitaxiée, l'oxyde qui en résulte est ensuite retiré et une région active ACTp en alliage de silicium-germanium a été formée localement. Les régions actives ACTn des futurs transistors NMOS sont préservées en silicium intrinsèque.

Dans l'étape 103 on a également formé des tranchées d'isolation peu profonde STI de manière à délimiter les régions actives ACTn, ACTp des futures transistors NMOS et PMOS et des prises de contact dans des futures caissons du substrat porteur SUB.

A une étape 105, on a formé par implantation de dopants de type respectifs les caissons NW, PW dans le substrat porteur SUB.

A une étape 107, on forme les couches diélectriques de grille EG des futures transistors NMOS et PMOS, par exemple en déposant sur toute la face avant du substrat une couche diélectrique EG, ou une superposition de couches diélectriques, ayant une épaisseur totale supérieure à 3 nm, par exemple comprise entre 3,5 nm et 4,5 nm.

A une étape 109 on forme les régions conductrices de grille RG des transistors NMOS et PMOS, par exemple en déposant sur toute la couche diélectrique EG une structure conductrice RG pouvant comporte une couche de métal et un volume de silicium polycristallin par-dessus.

Les différentes structures de grilles EG, RG des transistors NMOS et PMOS sont ensuite définies par une gravure, typiquement par photolithographie, retirant la région conductrice de grille RG et la couche diélectrique de grille EG dans les parties situées en dehors du motif d'un masque. Dans la figure 3, les zones remplies par des hachures obliques montantes les plus serrées (« RG » dans la figure 1), représentent le résultat de la gravure des structures de grille EG, RG, et correspondent sensiblement au motif du masque.

Après la définition des structures de grilles EG, RG des transistors NMOS et PMOS, les régions de source et de drains S/D sont implantés dans les régions actives ACTn, ACTp de façon auto-alignée sur les structures de grille EG, RG, c'est-à-dire dans les parties des régions actives ACTn, ACTp qui ne sont pas masquées par les structures de grille EG, RG.

D'autre part, les transistors NMOS et PMOS des cellules mémoires sont électriquement connectés au moyen de via métallique verticaux et de pistes métalliques, par exemple tels que représentés sur la figure 3, où les carrés remplis d'une croix dans les deux diagonales correspondent aux emplacements des vias, et où les zones remplies par des hachures obliques montantes les moins serrées (VDD, N1, N2, WL, BL1, BL2) correspondent aux pistes métalliques.

Ainsi, à une étape 111, les cellules mémoires CLL sont fonctionnelles et peuvent être alimentées, par exemple à une tension d'alimentation VDD comprise entre 0,8 volts et 1,2 volts (0,8 V ≤ VDD ≤ 1,2 V) et sans polarisation arrière (BBn = BBp = 0V) dans le mode de fonctionnement de lecture-écriture ; et à une tension d'alimentation VDD de sensiblement 0,6 volts (VDD = 0,6 V) et avec des polarisation arrière inverses BBn, BBp de sensiblement -2 volts dans les caissons PW du type P et de sensiblement +2 volts dans les caisson NW de type N (BBn = -2 V ; BBp = +2V) dans le mode de fonctionnement de rétentions.

Par ailleurs, le procédé de fabrication des cellules mémoires utilise avantageusement des étapes de fabrication pouvant être déjà prévues par ailleurs dans un procédé de fabrication conventionnel, et ainsi être réalisé de manière complètement cointégrée et sans coût supplémentaire. En effet, d'autres circuits du dispositif semiconducteur DSM que le circuit de mémoire vive statique peuvent incorporer des transistors « moyenne tension », c'est-à-dire des transistors ayant des couches diélectriques de grille d'épaisseurs comprises entre 3,5 nm et 4,5 nm et destinés à fonctionner à des tensions comprises entre 1,2 volts et 1,8 volts, dont les étapes de fabrication correspondent sensiblement aux étapes de fabrication 101-111 des transistors NMOS et PMOS. D'autre part, les autres circuits du dispositif semiconducteur DSM peuvent incorporer des transistors « basse tension », c'est-à-dire des transistors ayant des couches diélectriques de grille d'épaisseurs comprises entre 1 nm et 1,5 nm et destinés à fonctionner à des tensions comprises entre 0,5 volts et 1,2 volts.

En résumé, il a été décrit des modes de réalisation d'une cellule mémoire vive statique d'un dispositif semiconducteur DSM du type FDSOI, comportant des transistors NMOS et des transistors PMOS dans une configuration à caisson réguliers permettant d'appliquer une polarisation arrière inverse indépendamment sur les transistors NMOS et PMOS. L'épaisseur supérieure à 3 nanomètres des couches diélectriques de grille EG permet de supprimer les fuites de courant de grille. Les régions active ACTp des transistors PMOS en alliage de silicium-germanium contraint en compression dans la direction L du canal permet d'abaisser la tension de seuil des transistors PMOS, et ainsi d'assurer une stabilité suffisante en lecture et en écriture. L'architecture de région active continue ACTp des transistors PMOS permet d'éviter la relaxation de la contrainte en compression de l'alliage de silicium-germanium, ce qui évite en conséquence une variabilité et une augmentation de la tension de seuil des transistors PMOS. Par ailleurs, le procédé de fabrication des cellules mémoires peut utiliser des étapes de fabrication conventionnelles, et ainsi être mis en oeuvre de façon entièrement cointégrée sans coût dédié supplémentaire.

## Revendications

1. Dispositif semiconducteur du type silicium sur isolant comprenant un film semiconducteur (ACTn, ACTp) séparé d'un substrat porteur (SUB) par une région diélectrique enterrée (BOX), le dispositif comprenant un circuit de mémoire vive statique muni d'au moins une cellule-mémoire (CLL) comportant des transistors NMOS (NM) et des transistors PMOS (PM) comprenant chacun une couche diélectrique de grille (EG) ayant une épaisseur (tEG) supérieure à 3 nanomètres et une région active (ACTn, ACTp) dans le film semiconducteur respectif, la région active des transistors PMOS (ACTp) étant faite en alliage de silicium-germanium.

2. Dispositif selon la revendication 1, dans lequel les couches diélectriques de grille (EG) des transistors NMOS et des transistors PMOS ont une épaisseur (tEG), prise entre la région active (ACTn, ACTp) et une région conductrice de grille (RG), comprise entre 3,5 nanomètres et 6 nanomètres.

3. Dispositif selon l'une des revendications 1 ou 2, dans lequel les régions actives (ACTn, ACTp) s'étendent dans le circuit de mémoire le long d'une première direction de manière à incorporer d'autres cellules-mémoires, et de manière à ne pas relaxer une contrainte en compression dans la première direction de l'alliage de silicium-germanium.

4. Dispositif selon l'une des revendications précédentes, dans lequel les transistors NMOS (NM) et les transistors PMOS (PM) sont situées dans des caissons respectivement dopés (PW, NW) du substrat porteur (SUB), le dispositif comportant un circuit de polarisation configuré pour générer, dans les caissons semiconducteurs respectifs (PW, NW) du substrat porteur (SUB), des tensions (BBn, BBp) adaptées pour des polarisations arrières inverses des transistors PMOS et NMOS.

5. Dispositif selon la revendication 4, dans lequel les transistors NMOS (NM) sont situés dans un caisson (PW) dopé de type P dans le substrat porteur (SUB), les transistors PMOS (PM) sont situés dans un caisson (NW) dopé de type N dans le substrat porteur (SUB), et le circuit de polarisation est configuré pour générer une tension de polarisation arrière inverse (BBn) comprise entre 0 volt et -2 volts dans les caissons (PW) dopés de type P, et une tension de polarisation arrière inverse (BBp) comprise entre 0 volt et +2 volts dans les caissons (NW) dopés de type N.

6. Dispositif selon l'une des revendications 4 ou 5, dans lequel le circuit de polarisation est configuré pour générer lesdites tensions (BBn, BBp) adaptées pour des polarisations arrières inverses des transistors PMOS et NMOS, dans un mode de rétention de donnée de ladite cellule-mémoire (CLL) et pas dans un mode de lecture-écriture de ladite cellule-mémoire (CLL), le circuit de polarisation étant configuré pour générer une tension d'alimentation (VDD) pour ladite cellule-mémoire (CLL) ayant un niveau nominal dans le mode de lecture-écriture, et ayant 50% à 85% du niveau nominal dans le mode de rétention de donnée.

7. Procédé de fabrication d'un dispositif semiconducteur du type silicium sur isolant comprenant un film semiconducteur (ACTn, ACTp) séparé d'un substrat porteur (SUB) par une région diélectrique enterrée (BOX), comprenant une fabrication d'au moins une cellule-mémoire (CLL) d'un circuit de mémoire vive statique comprenant :
une fabrication de transistors NMOS (NM) et de transistors PMOS (PM) comprenant chacun une formation d'une région active (ACTn, ACTp) dans le film semiconducteur respectif, et une formation d'une couche diélectrique de grille (EG) ayant une épaisseur (tEG) supérieure à 3 nanomètres, la région active des transistors PMOS (ACTp) étant faite en alliage de silicium-germanium.

8. Procédé selon la revendication 7, dans lequel les couches diélectriques de grille (EG) des transistors NMOS et des transistors PMOS ont une épaisseur (tEG), prise entre la région active (ACTn, ACTp) et une région conductrice de grille (RG), comprise entre 3,5 nanomètres et 6 nanomètres.

9. Procédé selon l'une des revendications 7 ou 8, dans lequel les régions actives (ACTn, ACTp) sont faites en s'étendant dans le circuit de mémoire le long d'une première direction de manière à incorporer d'autres cellules-mémoires, et de manière à ne pas relaxer une contrainte en compression dans la première direction de l'alliage de silicium-germanium (ACTp).

10. Procédé selon l'une des revendications 7 à 9, dans lequel la fabrication des transistors NMOS (NM) et des transistors PMOS (PM) comprend une formation de caissons semiconducteurs respectivement dopés (PW, NW) dans le substrat porteur (SUB), les transistors PMOS et NMOS (NM, PM) étant situés dans les caissons ayant un type de dopage respectif, le procédé comprenant en outre une fabrication d'un circuit de polarisation apte à générer, dans les caissons semiconducteurs respectifs (PW, NW) du substrat porteur (SUB), des tensions (BBn, BBp) adaptées pour des polarisations arrières inverses des transistors PMOS et NMOS.

11. Procédé selon la revendication 10, dans lequel les caissons (PW) dans lesquels se situent les transistors NMOS (NM) sont dopés de type P, les caissons (NW) dans lesquels se situent les transistors PMOS (PM) sont dopés de type N, et le circuit de polarisation est fabriqué de manière à générer une tension de polarisation arrière inverse (BBn) comprise entre 0 volt et -2 volts dans les caissons (PW) dopés de type P, et une tension de polarisation arrière inverse (BBp) comprise entre 0 volt et +2 volts dans les caissons (NW) dopés de type N.

12. Procédé selon l'une des revendications 10 ou 11, dans lequel le circuit de polarisation est fabriqué de manière à générer lesdites tensions (BBn, BBp) adaptées pour des polarisations arrières inverses des transistors PMOS et NMOS, dans un mode de rétention de donnée de ladite cellule-mémoire (CLL) et pas dans un mode de lecture-écriture de ladite cellule-mémoire (CLL), le circuit de polarisation étant fabriqué de manière à générer une tension d'alimentation (VDD) pour ladite cellule-mémoire (CLL) ayant un niveau nominal dans le mode de lecture-écriture, et ayant 50% à 85% du niveau nominal dans le mode de rétention de donnée.
